Europäisches Patentamt

European Patent Office

Office européen des brevets

(11) Veröffentlichungsnummer: **0 270 065 B1**

(12) **EUROPÄISCHE PATENTSCHRIFT**

(45) Veröffentlichungstag der Patentschrift: **19.02.92**

(51) Int. Cl.⁵: **H05K 7/14**

(21) Anmeldenummer: **87117715.0**

(22) Anmeldetag: **30.11.87**

(54) **Steckeinschub für elektrische Nachrichtentechnik.**

(30) Priorität: **03.12.86 DE 3641210**

(43) Veröffentlichungstag der Anmeldung:
**08.06.88 Patentblatt 88/23**

(45) Bekanntmachung des Hinweises auf die
Patenterteilung:
**19.02.92 Patentblatt 92/08**

(84) Benannte Vertragsstaaten:
**DE FR GB IT NL SE**

(56) Entgegenhaltungen:
**CH-A- 377 902**
**DE-U- 7 716 440**
**FR-A- 1 367 798**

(73) Patentinhaber: **SIEMENS AKTIENGESELL-
SCHAFT**
**Wittelsbacherplatz 2**
**W-8000 München 2(DE)**

(72) Erfinder: **Engert, Stefan, Dipl.-Ing. (FH)**
**Zänglweg 18**
**W-8000 München 83(DE)**
Erfinder: **Thalkofer, Bolko**
**Bernaysstrasse 15**
**W-8000 München 45(DE)**

Rank Xerox (UK) Business Services

**Beschreibung**

Die Erfindung bezieht sich auf einen Steckeinschub für die elektrische Nachrichtentechnik in dessen Innenraum eine steckbare Leiterplatte eingeschoben ist.

Bei Steckbaugruppen der elektrischen Nachrichtentechnik, zum Beispiel Spannungswandlern, sind häufig aus Schirmungsgründen Metallgehäuse vorgesehen. Derartige Gehäuse haben üblicherweise an den inneren Längsseiten Führungsprägungen zum Einschieben von steckbaren Leiterplatten. An den Außenseiten haben sie andererseits Führungen zum Einschieben in Baugruppenträgern, zum Beispiel der Bauweise 7R oder 19 Zoll.

Der Erfindung liegt die Aufgabe zugrunde, diese Führungen sowohl der Leiterplatte als auch des Gehäuses zu vereinfachen.

Dies wird bei einer Einrichtung der eingangs genannten Art gemäß der Erfindung dadurch erreicht, daß zur Führung der Leiterplatte im Einschub und gleichzeitig zur Führung des Einschubs im übergeordneten Gehäuseeinsatz beidseits des Einschubs je eine Führungs-Schiene vorgesehen ist, die in geringen Abständen auf der Innenseite hakenartige Ansätze hat, mittels derer sie in entsprechende Durchbrüche in den Seitenwänden des Einschubs einhakbar ist und daß diese hakenartigen Ansätze in Längsrichtung auf eine der Dicke des Leiterplattenrandes entsprechenden Distanz unterbrochen, also zweigeteilt sind, so daß zwischen diese hakenartigen Ansätze im Inneren des Einschubs die Leiterplatte einschiebbar ist und die Führungsschienen an den Seitenwänden Gleitschienen für entsprechende Aufnahmeschienen im übergeordneten Gehäuse bilden.

Vorteilhaft haben die Schienen wenigstens an einem Ende Nasen, die ebenfalls in Richtung Einschubinneres ragen und in entsprechende Durchbrechungen in dessen Seitenwänden einrastbar sind.

Nachstehend wird die Erfindung anhand eines in den Figuren dargestellten Ausführungsbeispiels näher erläutert.

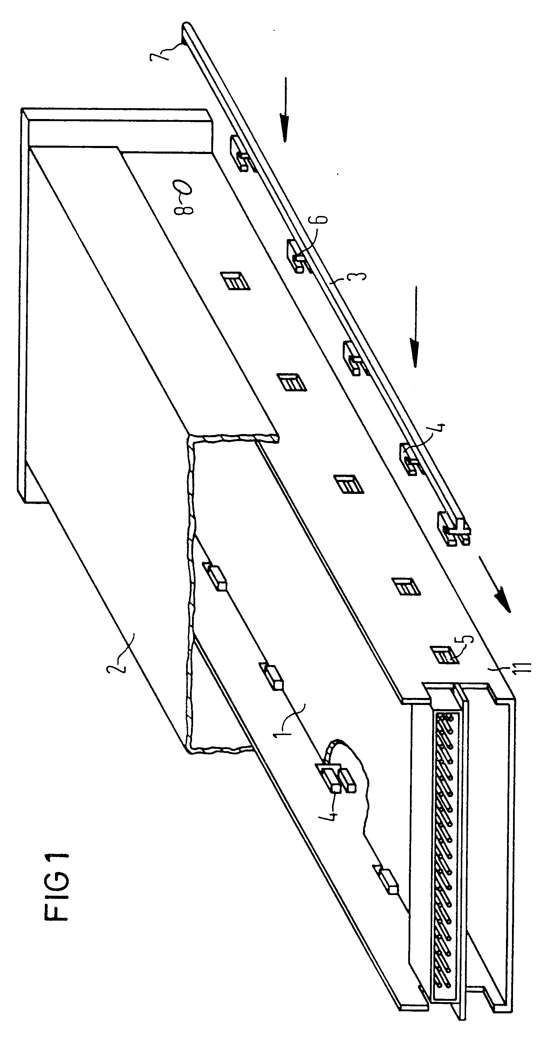

Die Figur 1 zeigt ein Einschubgehäuse mit einer darin befindlichen Leiterplatte.

Die Figur 2 zeigt in Explosivdarstellung den Einschub mit dem übergeordneten Gehäuse.

Eine Leiterplatte 1 ist in einem Einschubgehäuse 2 und dieses Einschubgehäuse in einem übergeordneten Gehäuseeinsatz 9 je Längsseite mit einer Kunststoffschiene 3 gleichzeitig geführt. Die Führung für den Einschub bildet eine durchlaufend rechteckige Leiste 3, die mittels hakenförmiger Ansätze 4 in entsprechenden Durchbrechungen 5 der Seitenwand 11 des Einschubs befestigbar ist. Die hakenförmigen Ansätze werden dabei durch rechteckförmige Durchbrechungen 5 hindurchgesteckt und bis zum Anschlag 6 am Fuß der Haken eingeschoben. Eine Rastnase 7, die an wenigstens einem Ende je Schiene befestigt ist, kann zusätzlich zur Lagesicherung in eine entsprechende Durchbrechung 8 an der Gehäuseseitenwand eingerastet werden.

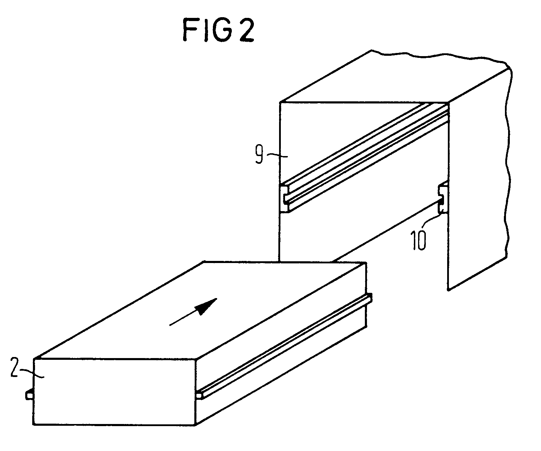

Die Leiste 3 bildet so zunächst die Führung für das Einschubgehäuse 2, das gemäß Figur 2 als geschlossener Kasten ausgebildet ist. Diese Schienen haben im übergeordneten Gehäuse entsprechend Gegenstücke 10, in die sie einschiebbar sind. Das übergeordnete Gehäuse ist selbst wieder zum Beispiel ein Baugruppenträger der Bauweise 7R.

Die Haken sind nicht nur mehrfach auf den Längsseiten des Einschubs vorhanden, sondern sie sind in Längsrichtung zweigeteilt und zwar auf eine derartige Weise, daß sie zwischen sich den Rand der Leiterplatte aufnehmen können. Die Haken bilden also sozusagen gleichzeitig die Prägungen für die steckbare Leiterplatte 1.

Auf diese Weise wird mit einem relativ einfachen, spritztechnisch herstellbaren Kuntstoffelement sowohl die Führung für die Leiterplatte als auch die Führung für den Einschub gleichzeitig verwirklicht.

Die Haken werden zweckmäßig noch zum besseren Einfädeln der Leiterplatte in Einsteckrichtung der Leiterplatte etwas trichterförmig angeschrägt.

Auf diese Weise wird nicht nur eine durchgehende Außenführung für den Einschub erreicht sondern auch eine einfachere Herstellbarkeit der mit sogenannten NC-Lochern gefertigten Gehäuse, da nur Lochungen und keine Ausprägungen mehr erforderlich sind. Beim Biegen der Gehäuseteile können keine Verschiebungen der sonst notwendigen Prägungen mehr erfolgen. Die isolierenden Haken bedeuten gleichzeitig eine größere Ausnutzbarkeit der Verdrahtung auf der Leiterplatte.

**Patentansprüche**

1. Steckeinschub für die elektrische Nachrichtentechnik, in dessen Innenraum eine steckbare Leiterplatte eingeschoben ist, **dadurch gekennzeichnet,** daß zur Führung der Leiterplatte (1) im Einschub (2) und gleichzeitig zur Führung des Einschubs (2) im übergeordneten Gehäuseeinsatz (9) beidseits des Einschubs (2) je eine Führungsschiene (3) vorgesehen ist, die in geringen Abständen auf der Innenseite hakenartige Ansätze (4) hat, mittels derer sie in entsprechende Durchbrüche (5) in den Seitenwänden des Einschubs einhakbar ist und daß diese hakenartigen Ansätze (4) in Längsrichtung auf eine der Dicke des Leiterplattenrandes entsprechenden Distanz unterbrochen, also zweigeteilt sind, so daß zwischen diese hakenartigen Ansätze (4) im Inneren des Einschubs (2) die Leiterplatte einschiebbar ist und die Führungsschienen (3) an den Seitenwänden (11) Gleitschienen für entsprechende Aufnahmeschienen (10) im übergeordneten Gehäuse (9) bilden.

2. Steckeinschub nach Anspruch 1,
**dadurch gekennzeichnet,**
daß die Schienen (3) wenigstens an einem Ende eine Nase (7) haben, die ebenfalls in Richtung Einschubinneres ragt und in eine entsprechende Durchbrechung (8) in der Seitenwand des Einschubs einrastbar ist.

**Claims**

1. Plug-in drawer for electrical telecommunications, into the internal space of which a plug-in printed circuit board is inserted, characterised in that in order to guide the printed circuit board (1) in the drawer (2) and at the same time in order to guide the drawer (2) in the superordinate housing subrack (9) in each case a guide rail (3) is provided on each side of the drawer (2), which rail has hook-like projections (4) on the inside at small intervals, by means of which it can be hooked into corresponding holes (5) in the side walls of the drawer, and in that these hook-like projections (4) are interrupted, that is to say divided in two, in the longitudinal direction over a distance corresponding to the thickness of the printed circuit board edge so that the printed circuit board can be inserted between these hook-like projections (4) inside the drawer (2) and the guide rails (3) form on the side walls (11) sliding rails for corresponding receiving rails (10) in the superordinate housing (9).

2. Plug-in drawer according to Claim 1, characterised in that the rails (3) have at least at one end a lug (7) which also projects in the direction of the inside of the drawer and can be engaged in a corresponding opening (8) in the side wall of the drawer.

**Revendications**

1. Tiroir enfichable pour la technique électrique de transmission d'informations, dans l'espace intérieur duquel est insérée une plaquette à circuits imprimés enfichable, caractérisé par le fait
que pour le guidage de la plaquette à circuits imprimés (1) dans le tiroir (2) et simultanément pour le guidage du tiroir (2) dans l'insert de boîtier (9) superposé, il est prévu, des deux côtés du tiroir (2), des rails de guidage respectifs (3), qui, sur le côté intérieur, possèdent des éléments saillants en forme de crochets (4) séparés par une faible distance et à l'aide desquels les rails peuvent être accrochés dans des ouvertures correspondantes (5) ménagées dans les parois latérales du tiroir, et que ces éléments saillants en forme de crochets (4) sont interrompus dans la direction longitudinale, sur une distance qui correspond à l'épaisseur du bord de la plaquette à circuits imprimés, c'est-à-dire sont subdivisés en deux éléments, de sorte que la plaquette à circuits imprimés peut être insérée entre ces éléments saillants en forme de crochets (4) à l'intérieur du tiroir (2) et que les rails de guidage (3) forment, sur les parois latérales (11), des glissières pour des rails de logement correspondants (10) disposés dans le boîtier superposé (9).

2. Tiroir enfichable suivant la revendication 1, caractérisé par le fait que les rails (3) possèdent, au moins à une extrémité, un ergot (7), qui fait également saillie vers l'intérieur du tiroir et peut être encliqueté dans une ouverture correspondante (8) ménagée dans la paroi latérale du tiroir.

FIG 1

EP 0 270 065 B1

# FIG 2

9

10

2